# FASCICULE DE BREVET EUROPEEN

(11) **EP 2 163 870 B1**
(45) Date de publication et mention de la délivrance du brevet: **27.03.2013**
(21) Numéro de dépôt: 09166608.1
(22) Date de dépôt: 28.07.2009
(51) Int. Cl.: G01J 3/02, G01J 3/28, G01J 3/36, H01L 27/146, H01L 31/0232, G02B 23/00, G02B 5/28

(54) **Filtre multispectral pour détecteur d'images, dispositif de détection d'images amélioré pour un imageur multispectral et imageur multispectral comportant ce filtre**
Multispektralfilter für Bildsensor, verbesserte Bilddetektionsvorrichtung für einen Multispektralbildgenerator und diesen Filter enthaltender Multispektralbildgenerator
Multispectral filter for image sensor, improved image-sensing device for a multispectral imager and multispectral imager incorporating this filter

(30) Priorité: 12.09.2008 FR 0805019
(43) Date de publication de la demande: 17.03.2010
(73) Titulaire: Thales, 92200 Neuilly Sur Seine (FR)
(72) Inventeur: Blanc, Jean-François, 06210, MANDELIEU (FR); Garin, Stéphane, 06550, LA ROQUETTE SUR SIAGNE (FR)
(74) Mandataire: Nguyen, Dominique

(56) Documents cités:
- EP-A- 0 690 295
- EP-A- 1 801 553
- US-A- 4 633 078
- US-A- 5 135 183
- US-A- 5 608 456
- US-A1- 2003 117 621
- US-A1- 2005 094 160
- HERBERT GROSS: "Handbook of Optical Systems" 19 mars 2008 (2008-03-19), WILEY-VCH , WEINHEIM , XP002525367 * page 790, alinéa 43.12.1 - page 791 *

## Description

La présente invention concerne un filtre multispectral pour dispositif de détection d'images, un dispositif de détection d'images amélioré permettant la suppression des images fantômes au plan focal d'un imageur multispectral et un imageur multispectral comportant ce filtre. Elle s'applique notamment au domaine des télescopes réflecteurs du type « Off Axis » pour lesquels le faisceau lumineux collecté par le système optique du télescope et réfléchi par le système optique du télescope est décalé angulairement par rapport au plan focal de l'imageur.

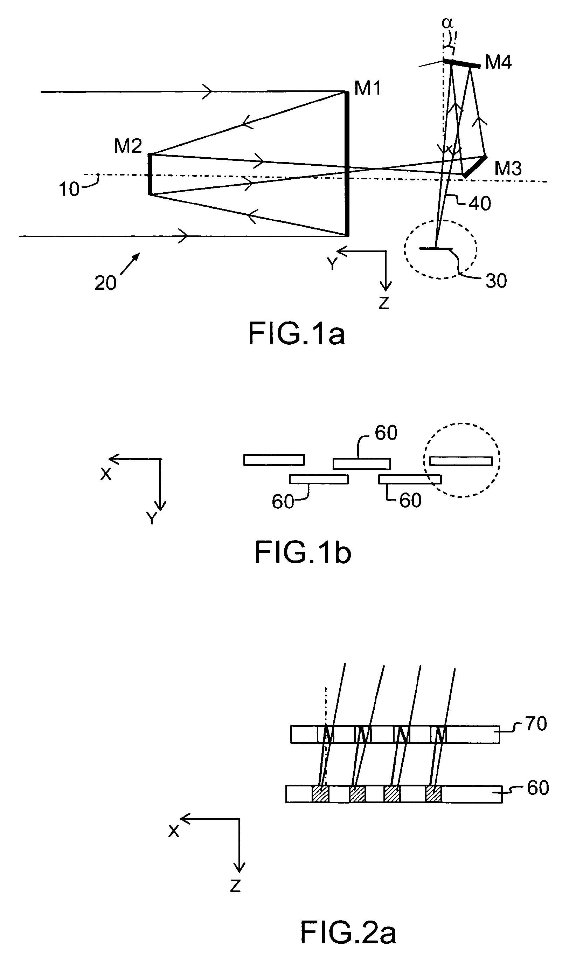

Un télescope Off Axis, tel que par exemple un télescope de type Korsch ou autre, est un système optique, à symétrie de révolution autour d'un axe longitudinal, comportant une pluralité de miroirs disposés selon l'axe longitudinal, dont la pupille de sortie (non représentée) et/ou le champ de prise de vue est excentré. La figure 1a représente un schéma d'un exemple de système optique d'un télescope Off Axis, selon un plan de coupe YZ. Sur cette figure, le système optique 20 du télescope comporte trois miroirs asphériques M1, M2, M4 centrés sur l'axe longitudinal 10 du système optique 20 et un quatrième miroir M3, miroir plan incliné (à 45° sur la figure). Les deux miroirs M1, M2 sont disposés perpendiculairement à l'axe longitudinal 10 tels que le deuxième miroir M2 est disposé en amont du premier miroir M1 par rapport au trajet d'un faisceau lumineux incident. Le miroir M3 est un miroir plan incliné par rapport à l'axe 10 et a une face réfléchissante disposée en regard du miroir Off Axis M4. Un faisceau lumineux incident provenant d'une scène observée par le télescope est réfléchi une première fois par le premier miroir M1 en direction du deuxième miroir M2 disposé en amont, puis est réfléchi une deuxième fois par le deuxième miroir M2 en direction du troisième miroir M3 situé en aval du miroir M1. Le miroir M3 réfléchit le faisceau lumineux provenant du miroir M2 en direction du miroir Off Axis M4 qui renvoie le faisceau focalisé 40 dans un plan focal 30, parallèle à l'axe longitudinal 10 et décalé transversalement par rapport audit axe longitudinal 10, le plan focal 30 étant le foyer optique du télescope. Le faisceau focalisé 40 n'est pas perpendiculaire au plan focal 30 du télescope mais arrive sur le plan focal 30 avec un angle d'incidence oblique α. La détection des images collectées par le télescope peut alors être réalisée en plaçant des détecteurs dans le plan focal 30 du télescope. Les détecteurs sont associés à des filtres d'entrée ou à un filtre multispectral permettant d'observer les images dans différentes fenêtres spectrales. Le document EP 1 801 553 décrit un exemple de structure multi-couches placée en entrée d'un détecteur, cependant ce type de structure a une fonction de disperseur spectral et il n'est pas aisé de définir des fenêtres spectrales avec précision. L'invention ne concerne pas ce type de structure mais des filtres à bandes dont les bandes sont espacées d'une distance prédéfinie et dont le spectre est prédéterminé.

La figure 1 b montre un zoom en vue de dessus, d'un exemple de disposition des détecteurs selon un plan XY parallèle au plan focal. Sur cette figure, à titre d'exemple non limitatif, sont représentées cinq barrettes 60 de détecteurs, disposées par exemple en quinconce. Chaque barrette peut comporter plusieurs lignes de détecteurs, par exemple quatre lignes, chaque ligne étant affectée à une bande spectrale. Les détecteurs peuvent être agencés sous forme de barrettes ou de matrices.

Le faisceau lumineux focalisé arrivant sur les détecteurs par l'intermédiaire des filtres n'étant pas perpendiculaire aux filtres mais ayant un angle d'incidence oblique α, ce type d'imageur présente l'inconvénient d'engendrer des échos parasites dus à des réflexions multiples du faisceau lumineux 40 aux différentes interfaces entre les faces des filtres et les détecteurs. Au niveau des interfaces du filtre, des réflexions multiples ont lieu à la fois à l'intérieur des bandes du filtre et entre les bandes du filtre. Ces échos parasites sont responsables de l'apparition d'images parasites, appelées « images fantômes » qui gênent l'interprétation des images de la scène observée.

Le document US 2003/117621 décrit un couvercle de boîtier de détecteur en forme de lame prismatique pour éliminer des images fantômes, cependant la lame n'a aucune fonction spectrale.

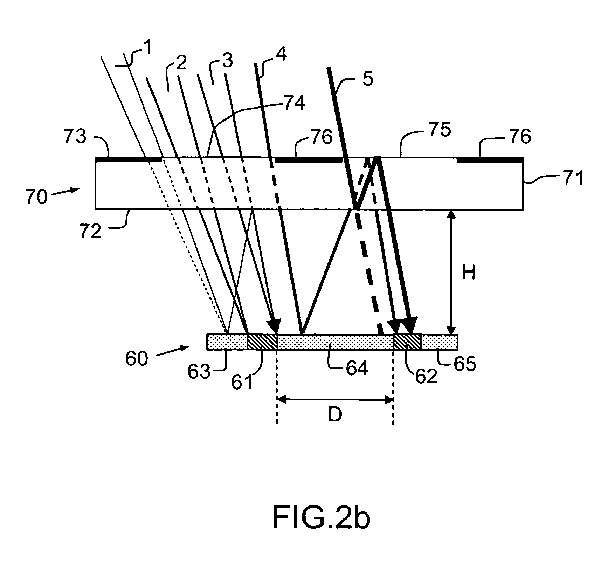

Pour résoudre ce problème, il est connu d'utiliser un filtre multispectral comportant une lame à faces parallèles sur laquelle sont déposées, sous formes de couches minces, différentes bandes spectrales, la lame étant associée à plusieurs diaphragmes délimitant le filtre et les bandes spectrales du filtre. Les figures 2a et 2b montrent un zoom, vu en coupe selon un plan XZ, d'une barrette de détecteurs 60 comportant un filtre multispectral 70 en entrée. Les diaphragmes peuvent être de type mécanique ou réalisés par des absorbants disposés entre les bandes spectrales du filtre et de part et d'autre du filtre. Cependant, cette solution, décrite plus en détails ci-après, ne permet pas de rejeter toutes les images fantômes. De plus, elle impose, après la réalisation des dépôts de couches minces pour obtenir les différentes bandes spectrales du filtre et de réaliser un dépôt d'un matériau absorbant entre les bandes spectrales, ce qui est très complexe à réaliser.

La présente invention a pour but de remédier à ces inconvénients en proposant un filtre multispectral permettant d'éliminer de façon plus efficace toutes les réflexions multiples à l'intérieur des bandes du filtre et entre les bandes du filtre.

Un autre but de l'invention est de proposer un filtre permettant de s'affranchir de la réalisation d'un dépôt de matériau absorbant entre les bandes spectrales du filtre et donc plus simple à réaliser.

Un autre but de l'invention, est de réaliser un dispositif de détection d'images amélioré, permettant la suppression de toutes les images fantômes au plan focal d'un imageur multispectral.

A cet effet, l'invention a pour objet un filtre multispectral pour dispositif de détection d'images selon la revendication 1.

Avantageusement, le filtre est dépourvu de matériau absorbant et de diaphragme entre les différentes bandes spectrales.

Avantageusement, chaque bande spectrale est constituée d'un dépôt d'au moins un matériau laissant passer des longueurs d'ondes comprises dans ladite bande spectrale et rejetant toutes les autres longueurs d'ondes.

L'invention concerne aussi un dispositif de détection d'images amélioré pour un imageur multispectral, comportant une pluralité de détecteurs et au moins un filtre multispectral disposé en entrée des détecteurs, la première face interne de la lame prismatique étant disposée en regard des détecteurs.

Avantageusement, l'angle de prisme β peut être compris entre 0,1 et 20° et préférentiellement entre 1° et 10°.

Avantageusement, les détecteurs sont disposés selon au moins deux lignes parallèles entre elles et espacées d'une distance D égale à la distance séparant les bandes spectrales du filtre et la face interne de la lame prismatique est disposée à une distance H des détecteurs. La distance H peut être comprise entre 0,2mm et 30mm et la distance D peut être comprise entre 0,2mm et 2mm. Préférentiellement, la distance H est comprise entre 1mm et 15mm et la distance D est comprise entre 0,5mm et 2mm.

Chaque bande spectrale peut être constituée d'un dépôt d'au moins un matériau laissant passer des longueurs d'ondes comprises dans ladite bande spectrale et rejetant toutes les autres longueurs d'ondes.

L'invention concerne aussi un imageur multispectral comportant au moins un dispositif de détection d'images amélioré.

Avantageusement, l'imageur multispectral comporte des moyens optiques pour collecter des faisceaux lumineux incidents et des moyens optiques pour réfléchir les faisceaux incidents et focaliser les faisceaux réfléchis dans un plan focal situé au foyer optique de l'imageur, les faisceaux focalisés au plan focal ayant un angle d'incidence oblique par rapport au plan focal, le dispositif de détection d'images amélioré étant placé dans le plan focal de l'imageur multispectral.

Avantageusement, l'imageur multispectral est un imageur Off Axis.

D'autres particularités et avantages de l'invention apparaîtront clairement dans la suite de la description donnée à titre d'exemple purement illustratif et non limitatif, en référence aux dessins schématiques annexés qui représentent :
- figure 1a : un schéma d'un exemple de système optique d'un imageur du type télescope Off Axis, selon un plan de coupe YZ;
- figure 1b : un zoom en vue de dessus, d'un exemple de disposition des détecteurs selon un plan XY parallèle au plan focal de l'imageur de la figure 1a;
- figures 2a et 2b : deux vues schématiques en coupe, selon un plan XZ, d'un exemple de dispositif de détection d'images pour un imageur multispectral, selon l'art antérieur ;
- figures 3a et 3b : deux vues schématiques en coupe, selon un plan XZ, d'un exemple de dispositif de détection d'images pour un imageur multispectral, selon l'invention.

Sur les figures 2a et 2b sont représentées en coupe selon un plan XZ, deux lignes de détecteurs 61, 62 disposées dans un même plan XY, sensiblement parallèlement l'une par rapport à l'autre et espacées d'une distance D l'une de l'autre. Les lignes de détecteurs peuvent être par exemple placées sur une barrette 60 de type CCD (en anglais : charge coupled device). De part et d'autre de chaque ligne de détecteurs et entre les lignes de détecteurs peuvent être disposés des matériaux absorbants 63, 64, 65. En entrée des détecteurs, à une distance H en amont de ceux-ci, est placé un filtre multispectral 70, par exemple de type multi-bandes (en anglais : strip-filter). Le filtre multispectral 70 peut être constitué d'une lame 71, par exemple en verre, comportant deux faces parallèles, respectivement inférieure 72, et supérieure 73, sur laquelle ont été réalisés des dépôts de couches minces sous forme de plusieurs bandes 74, 75 disposées parallèlement les unes par rapport aux autres. A titre d'exemple, deux bandes spectrales 74, 75 réalisées sur la face supérieure 73 de la lame 71 sont représentées mais il pourrait y en avoir un nombre différent de deux. Généralement, il y a autant de lignes de détecteurs que de bandes spectrales, chaque ligne de détecteurs étant dédiée à la détection des faisceaux ayant traversé une bande spectrale donnée. Chaque bande spectrale 74, 75 est obtenue à partir de dépôts d'une ou de plusieurs couches minces de différents matériaux. La composition, la structure et l'épaisseur des couches minces sont calculées de manière connue, de façon à laisser passer des longueurs d'ondes comprises dans une bande spectrale prédéterminée et à rejeter toutes les autres longueurs d'ondes.. Un dépôt de matériau absorbant 76 peut être réalisé sur la face supérieure 73 de la lame 71 de part et d'autre des bandes spectrales et entre les bandes spectrales 74, 75. Ainsi, le matériau absorbant 76 s'étend sur toute la superficie de la face supérieure 73 de la lame, à l'exception des bandes spectrales 74, 75. Le matériau absorbant 76 peut par exemple, n'avoir des propriétés absorbantes que sur sa face interne au contact avec le filtre et avoir des propriétés réfléchissantes sur sa face externe exposée aux faisceaux entrant dans le filtre de façon à absorber tous les faisceaux lumineux réfléchis qui atteignent sa face interne et à réfléchir tous les faisceaux lumineux qui atteignent sa face externe.

La barrette de détecteurs est localisée dans le plan focal d'un imageur. Un faisceau lumineux 1, 2, 3, 4, 5 qui arrive sur le filtre multispectral peut être transmis directement aux détecteurs 61, 62 après avoir traversé le filtre 70, comme les faisceaux 2 et 3, ou être transmis après avoir été réfléchi sur l'une ou les deux faces de la lame 71 du filtre 70, ou sur le support des détecteurs, comme les faisceaux 1, 4, 5. Les transmissions après réflexions constituent des échos parasites qu'il faut éliminer car ils engendrent des images fantômes. Certaines réflexions parasites, dites intra-bandes, tel que le faisceau 1 de la figure 2b, sont éliminées en optimisant le paramètre H, correspondant à la distance séparant le filtre des détecteurs, par rapport au paramètre D, correspondant à l'écart entre deux lignes de détecteurs et à l'écart entre deux bandes spectrales. D'autres réflexions parasites, dites inter-bandes, tel que le faisceau 4 de la figure 2b, sont éliminées grâce à l'adjonction des traitements absorbants sur le filtre et/ou les espaces entre les lignes de détecteurs. Les réflexions internes au filtre, tel que le faisceau 5 de la figure 2, ne peuvent pas être éliminées. Or ces réflexions internes au filtre sont les réflexions les plus intenses pour les télescopes à faible ouverture et forte résolution et sont donc très gênantes. Les conséquences sont une dégradation de la qualité des images suivant les conditions d'éclairement de la scène observée. En particulier, l'observation de scènes à fortes luminances conduit à des points de saturation accompagnés d'échos parasites pouvant gêner l'interprétation des images. Enfin, ces échos peuvent être présents au niveau de zones faiblement lumineuses à proximité de zones fortement éclairées. Dans ce cas, les performances de bruits spatiaux peuvent s'en trouver altérées de manière significative et gênante car elles dépendent de la distribution spatiale des luminances observées.

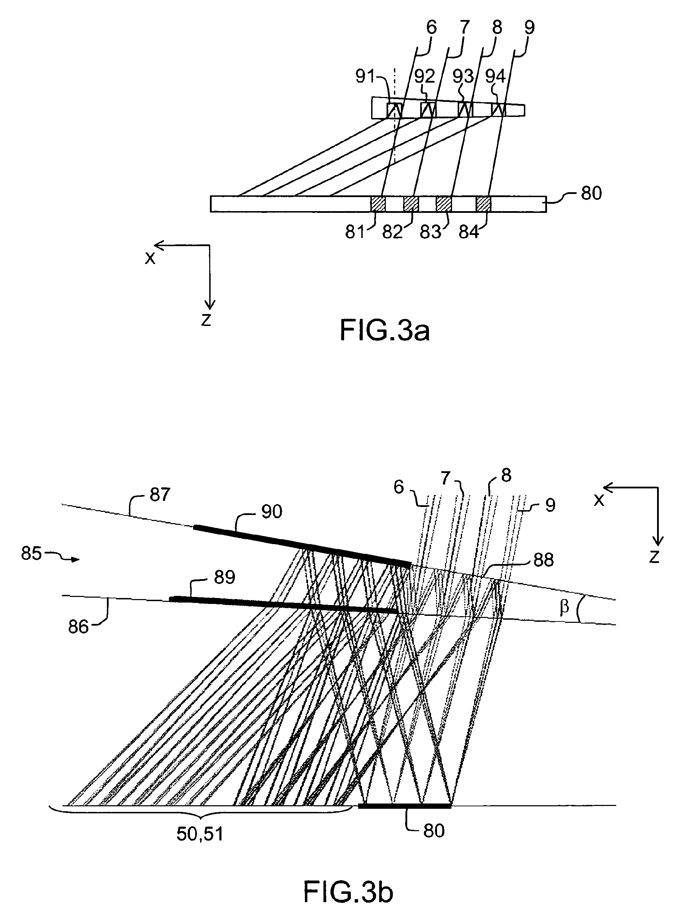

Les figures 3a et 3b montrent deux vues schématiques en coupe, selon un plan XZ, d'un exemple de dispositif de détection d'images pour un imageur multispectral, selon l'invention.

Sur la figure 3b, une matrice 80 de détecteurs comportant une pluralité de détecteurs, par exemple de type CCD, est schématisée. Les détecteurs comportent des surfaces collectrices de lumière qui peuvent être agencées sous la forme d'une matrice ou sous la forme de plusieurs barrettes, chaque barrette comportant une pluralité de détecteurs disposés selon une ou plusieurs lignes de détection. Sur la figure 3a, les détecteurs sont agencés en quatre lignes de détection 81, 82, 83, 84 approximativement parallèles et espacées d'une distance D prédéterminée. Une lame prismatique 85 est disposée en entrée des détecteurs à une distance H prédéterminée de la barrette. Une seule lame prismatique est nécessaire par barrette de détecteurs. La lame prismatique 85 comporte une première face interne 86 disposée en regard des détecteurs et une deuxième face externe 87. Les deux faces interne et externe 86, 87 de la lame prismatique 85 forment, entre elles, un angle de prisme β. Un filtre multispectral 88, par exemple de type multi-bandes, est déposé sur la lame prismatique. Le filtre multispectral 88 peut être déposé indifféremment sur la première ou la deuxième face 86, 87. Chaque bande spectrale est obtenue de manière connue à partir de dépôts d'une ou de plusieurs couches minces de différents matériaux choisis de façon que chaque bande spectrale laisse passer des longueurs d'ondes comprises dans ladite bande spectrale et rejette toutes les autres longueurs d'ondes. Sur les figures 3a et 3b, le filtre multispectral 88 comporte quatre bandes spectrales différentes 91, 92, 93, 94 permettant d'observer une scène dans quatre fenêtres spectrales différentes correspondant à des domaines de fréquences choisies, mais il pourrait y en avoir un nombre différent de quatre, il suffit que le nombre de bandes spectrales soit supérieur à 2. La distance qui sépare deux bandes spectrales est de préférence sensiblement égale à la distance D séparant deux lignes de détecteurs.

Les distances D et H sont calculées de façon à rejeter, en dehors des surfaces collectrices des détecteurs, toutes les réflexions parasites 50 qui peuvent se produire sur les détecteurs et sur la surface interne de la face interne de la lame prismatique 85. L'angle du prisme β est calculé de façon que toutes les réflexions parasites internes 51 à la lame prismatique 85 soient également rejetées en dehors des détecteurs. Cependant, l'angle β ne doit pas être trop important de façon à ne pas créer trop de dispersion spectrale dans la lame prismatique car cela aurait pour conséquence une dégradation inacceptable des images de la scène observée. Ainsi, l'angle de prisme β est optimisé selon un compromis entre un rejet des échos parasites et une minimisation de la dispersion spectrale dans la lame prismatique.

De manière générale, plus l'angle β est grand, plus la distance H entre les filtres et les détecteurs est petite. De même, plus l'espacement D entre les bandes spectrales et/ou entre les détecteurs est grand, plus la distance H entre les filtres et les détecteurs est grande.

Avantageusement, l'angle β peut être compris entre 0,1° et 20°, la distance H entre les filtres et les détecteurs peut être comprise entre 0,2 mm et 30 mm et l'espacement D entre les bandes spectrales et/ou entre les détecteurs peut être compris entre 0,2 mm et 5 mm.

Préférentiellement, pour minimiser la dispersion spectrale et la chute de qualité des images qui en découle, l'angle β est compris entre 1° et 10°, la distance H est comprise entre 1mm et 15 mm et l'espacement D est compris entre 0,5 mm et 2 mm pour quatre bandes spectrales.

Avantageusement, chacune des faces interne 86 et externe 87 de la lame prismatique 85 peut être équipée d'un diaphragme 89, 90, par exemple de type mécanique ou obtenu par des dépôts d'un matériau absorbant, délimitant le filtre multispectral 88 et permettant d'atténuer les réflexions parasites rejetées. Ces diaphragmes ne sont cependant pas indispensables. Aucun dépôt d'absorbant n'est réalisé entre les bandes du filtre 88, ni entre les lignes de détecteurs 81, 82, 83, 84. En effet l'utilisation d'absorbants est inutile puisque toutes les réflexions parasites sont rejetées en dehors des détecteurs.

Lorsque les détecteurs sont localisés dans le plan focal d'un imageur, un faisceau lumineux 6, 7, 8, 9 qui arrive sur le filtre multispectral 88 peut être transmis directement aux lignes de détecteurs 81, 82, 83, 84 après avoir traversé le filtre multispectral 88 et la lame prismatique 85, ou être réfléchi sur l'une ou les deux faces de la lame prismatique 85, ou sur les détecteurs. Tous les faisceaux réfléchis, même ceux internes à la lame prismatique 85 sont rejetés en dehors des détecteurs.

Le dispositif de détection d'images amélioré présente donc les avantages de supprimer complètement les images fantômes dans les imageurs, en particulier les imageurs Off Axis, et de permettre de simplifier la réalisation des filtres multispectraux en rendant les absorbants entre les bandes inutiles.

Bien que l'invention ait été décrite en relation avec un mode de réalisation particulier, il est bien évident qu'elle n'y est nullement limitée et qu'elle comprend tous les équivalents techniques des moyens décrits ainsi que leurs combinaisons si celles-ci entrent dans le cadre de l'invention.

## Revendications

1. Filtre multispectral pour dispositif de détection d'images, **caractérisé en ce qu'**il comporte une lame prismatique (85) comportant une première face interne (86) et une deuxième face externe (87), la première et la deuxième face (86, 87) étant inclinées l'une par rapport à l'autre d'un angle β et **en ce qu'**il comporte au moins deux bandes spectrales différentes (91, 92, 93, 94) déposées indifféremment sur la première ou la deuxième face (86, 87) de la lame prismatique (85), les différentes bandes spectrales (91, 92, 93, 94) étant espacées l'une de l'autre d'une distance (D) prédéterminée et l'angle de prisme β étant optimisé selon un compromis entre un rejet des échos parasites et une minimisation de la dispersion spectrale dans la lame prismatique.

2. Filtre multispectral selon la revendication 1, **caractérisé en ce que** le filtre est dépourvu de matériau absorbant et de diaphragme entre les différentes bandes spectrales (91, 92, 93, 94).

3. Filtre multispectral selon la revendication 2, **caractérisé en ce que** chaque bande spectrale (91, 92, 93, 94) est constituée d'un dépôt d'au moins un matériau laissant passer des longueurs d'ondes comprises dans ladite bande spectrale et rejetant toutes les autres longueurs d'ondes.

4. Dispositif de détection d'images amélioré pour un imageur multispectral, comportant une pluralité de détecteurs (81, 82, 83, 84) et au moins un filtre multispectral (88) selon l'une des revendications précédentes, le filtre multispectral étant disposé en entrée des détecteurs (81, 82, 83, 84), la première face interne (86) de la lame prismatique étant disposée en regard des détecteurs (81, 82, 83, 84).

5. Dispositif selon la revendication 4, **caractérisé en ce que** l'angle de prisme β est optimisé selon un compromis entre un rejet des échos parasites et une minimisation de la dispersion spectrale dans la lame prismatique.

6. Dispositif selon la revendication 5, **caractérisé en ce que** l'angle de prisme β est compris entre 0,1 ° et 20°.

7. Dispositif selon la revendication 6, **caractérisé en ce que** l'angle de prisme β est compris entre 1° et 10°.

8. Dispositif selon la revendication 4, **caractérisé en ce que** les détecteurs sont disposés selon au moins deux lignes parallèles entre elles et espacées d'une distance D égale à la distance séparant les bandes spectrales du filtre et **en ce que** la face interne de la lame prismatique est disposée à une distance H des détecteurs..

9. Dispositif selon la revendication 8, **caractérisé en ce que** la distance H est comprise entre 0,2mm et 30mm et la distance D est comprise entre 0,2mm et 2mm.

10. Dispositif selon la revendication 9, **caractérisé en ce que** la distance H est comprise entre 1 mm et 15mm et la distance D est comprise entre 0,5mm et 2mm

11. Imageur multispectral, **caractérisé en ce qu'**il comporte au moins un dispositif de détection d'images amélioré selon l'une quelconque des revendications 4 à 10.

12. Imageur multispectral selon la revendication 11 comportant des moyens optiques (20) pour collecter des faisceaux lumineux incidents et des moyens optiques (M1, M2, M3, M4) pour réfléchir les faisceaux incidents et focaliser les faisceaux réfléchis dans un plan focal (30) situé au foyer optique de l'imageur, les faisceaux focalisés au plan focal ayant un angle d'incidence oblique (50) par rapport au plan focal (30), **caractérisé en ce que** le dispositif de détection d'images amélioré est placé dans le plan focal (30) de l'imageur multispectral.

13. Imageur multispectral selon l'une des revendications 11 ou 12, **caractérisé en ce qu'**il est un imageur Off Axis.

## Claims

1. A multispectral filter for an image detection device, **characterised in that** it comprises a prismatic plate (85) comprising a first internal face (86) and a second external face (87), said first and second faces (86, 87) being inclined relative to each other at an angle β, and **in that** it comprises at least two different spectral bands (91, 92, 93, 94) that are deposited in the same way on said first or said second face (86, 87) of said prismatic plate (85), the different spectral bands (91, 92, 93, 94) being separated from each other by a predetermined distance (D) and the prism angle β being optimised according to a compromise between a rejection of spurious echoes and a minimisation of the spectral dispersion in said prismatic plate.

2. The multispectral filter according to claim 1, **characterised in that** said filter is devoid of absorbent material and of diaphragm between the different spectral bands (91, 92,93,94).

3. The multispectral filter according to claim 2, **characterised in that** each spectral band (91, 92, 93, 94) is constituted by a deposit of at least one material that transmits wavelengths that are included in said spectral band and that rejects all of the other wavelengths.

4. An improved image detection device for a multispectral imager, comprising a plurality of detectors (81, 82, 83, 84) and at least one multispectral filter (88) according to any one of the preceding claims, said multispectral filter being disposed at the input of said detectors (81, 82, 83, 84), the first internal face (86) of said prismatic plate being disposed opposite said detectors (81, 82, 83, 84).

5. The device according to claim 4, **characterised in that** said prism angle β is optimised according to a compromise between a rejection of spurious echoes and a minimisation of the spectral dispersion in said prismatic plate.

6. The device according to claim 5, **characterised in that** said prism angle β is between 0.1° and 20°.

7. The device according to claim 6, **characterised in that** said prism angle β is between 1° and 10°.

8. The device according to claim 4, **characterised in that** said detectors are disposed along at least two lines that are parallel to each other and separated by a distance D that is equal to the distance that separates the spectral bands of the filter, and **in that** the internal face of said prismatic plate is disposed at a distance H from said detectors.

9. The device according to claim 8, **characterised in that** the distance H is between 0.2mm and 30mm and the distance D is between 0.2 mm and 2 mm.

10. The device according to claim 9, **characterised in that** the distance H is between 1mm and 15mm and the distance D is between 0.5 mm and 2 mm.

11. A multispectral imager, **characterised in that** it comprises at least one improved image detection device according to any one of claims 4 to 10.

12. The multispectral imager according to claim 11, comprising optical means (20) for collecting incident light beams and optical means (M1, M2, M3, M4) for reflecting the incident beams and focusing the reflected beams in a focal plane (30) that is located at the optical focus of the imager, the beams focused at the focal plane having an oblique angle of incidence (50) relative to the focal plane (30), **characterised in that** the improved image detection device is placed in the focal plane (30) of the multispectral imager.

13. The multispectral imager according to claim 11 or 12, **characterised in that** it is an Off Axis imager.

## Patentansprüche

1. Multispektralfilter für eine Bilddetektionsvorrichtung, **dadurch gekennzeichnet, dass** es eine prismatische Platte (85) umfasst, die eine erste Innenfläche (86) und eine zweite Außenfläche (87) aufweist, wobei die erste und die zweite Fläche (86, 87) in einem Winkel β in Bezug zueinander geneigt sind, und dadurch, dass es wenigstens zwei verschiedene Spektralbänder (91, 92, 93, 94) umfasst, die auf gleiche Weise auf der ersten oder der zweiten Fläche (86, 87) der prismatischen Platte (85) angeordnet sind, wobei die verschiedenen Spektralbänder (91, 92, 93, 94) um einen vorbestimmten Abstand (D) voneinander beabstandet sind und wobei der Prismenwinkel β gemäß einem Kompromiss zwischen einer Rückweisung von Störechos und einer Minimierung der spektralen Dispersion in der prismatischen Platte optimiert ist.

2. Multispektralfilter nach Anspruch 1, **dadurch gekennzeichnet, dass** das Filter frei von absorptionsfähigem Material und Membran zwischen den verschiedenen Spektralbändern (91, 92, 93, 94) ist.

3. Multispektralfilter nach Anspruch 2, **dadurch gekennzeichnet, dass** jedes Spektralband (91, 92, 93, 94) von einer Auflage von wenigstens einem Material gebildet wird, das die in dem Spektralband enthaltenen Wellenlängen durchlässt und alle anderen Wellenlängen zurückweist.

4. Verbesserte Bilddetektionsvorrichtung für einen Multispektralbildgenerator, die mehrere Bilddetektoren (81, 82, 83, 84) und wenigstens ein Multispektralfilter (88) nach einem der vorherigen Ansprüche umfasst, wobei das Multispektralfilter am Eingang der Detektoren (81, 82, 83, 84) angeordnet ist, wobei die erste Innenfläche (86) der prismatischen Platte gegenüber den Detektoren (81, 82, 83, 84) angeordnet ist.

5. Vorrichtung nach Anspruch 4, **dadurch gekennzeichnet, dass** der Prismenwinkel β gemäß einem Kompromiss zwischen einer Rückweisung von Störechos und einer Minimierung der spektralen Dispersion in der prismatischen Platte optimiert ist.

6. Vorrichtung nach Anspruch 5, **dadurch gekennzeichnet, dass** der Prismenwinkel β zwischen 0,1° und 20° liegt.

7. Vorrichtung nach Anspruch 6, **dadurch gekennzeichnet, dass** der Prismenwinkel β zwischen 1° und 10° liegt.

8. Vorrichtung nach Anspruch 4, **dadurch gekennzeichnet, dass** die Detektoren entlang wenigstens zwei zueinander parallelen Linien angeordnet und um einen Abstand D beabstandet sind, der gleich dem Abstand ist, der die Spektralbänder des Filters trennt, und dadurch, dass die Innenfläche der prismatischen Platte in einem Abstand H von den Detektoren angeordnet ist.

9. Vorrichtung nach Anspruch 8, **dadurch gekennzeichnet, dass** der Abstand H zwischen 0,2 mm und 30 mm liegt und der Abstand D zwischen 0,2 mm und 2 mm liegt.

10. Vorrichtung nach Anspruch 9, **dadurch gekennzeichnet, dass** der Abstand H zwischen 1 mm und 15 mm liegt und der Abstand D zwischen 0,5 mm und 2 mm liegt.

11. Multispektralbildgenerator, **dadurch gekennzeichnet, dass** er wenigstens eine verbesserte Bilddetektionsvorrichtung nach einem der Ansprüche 4 bis 10 umfasst.

12. Multispektralbildgenerator nach Anspruch 11, der optische Mittel (20) zum Sammeln von einfallenden Lichtstrahlen und optische Mittel (M1, M2, M3, M4) zum Reflektieren der einfallenden Strahlen und zum Fokussieren der reflektierten Strahlen in einer Fokalebene (30) umfasst, die sich im optischen Fokus des Bildgenerators befindet, wobei die auf die Fokalebene fokussierten Strahlen einen schrägen Eingangswinkel (50) in Bezug auf die Fokalebene (30) haben, **dadurch gekennzeichnet, dass** die verbesserte Bilddetektionsvorrichtung in der Fokalebene (30) des Multispektralbildgenerators platziert ist.

13. Multispektralbildgenerator nach Anspruch 11 oder 12, **dadurch gekennzeichnet, dass** er ein Bildgenerator mit versetzter Achse (Off Axis) ist.
